# EUROPÄISCHE PATENTSCHRIFT

(11) **EP 3 028 295 B1**
(45) Veröffentlichungstag und Bekanntmachung des Hinweises auf die Patenterteilung: **21.10.2020**
(21) Anmeldenummer: 13774373.8
(22) Anmeldetag: 25.09.2013
(51) Int. Cl.: H01L 21/67, H01L 21/18

(54) **VERFAHREN ZUM BONDEN VON SUBSTRATEN**
METHOD FOR BONDING SUBSTRATES
PROCÉDÉ DE CONNEXION DE SUBSTRATS

(43) Veröffentlichungstag der Anmeldung: 08.06.2016
(73) Patentinhaber: Ev Group E. Thallner GmbH, 4782 St. Florian am Inn (AT)
(72) Erfinder: WIMPLINGER, Markus, A-4910 Ried im Innkreis (AT); DRAGOI, Viorel, A-4782 Sankt Florian/Inn (AT); FLÖTGEN, Christoph, A-4782 St. Florian/Inn (AT)
(74) Vertreter: Schneider, Sascha
(86) Internationale Anmeldenummer: PCT/EP2013/069900
(87) Internationale Veröffentlichungsnummer: WO 2015/043624

(56) Entgegenhaltungen:
- US-A1- 2009 286 382
- US-A1- 2011 207 291

## Beschreibung

Die vorliegende Erfindung betrifft ein Verfahren zum Erzeugen eines elektrisch leitfähigen Direktbonds zwischen einer Bondseite eines ersten Substrats und einer Bondseite eines zweiten Substrats.

Insbesondere beim Bonden von metallischen oder metallisierten Substraten, Substraten mit metallischen Oberflächen, Halbleitersubstraten oder Verbundhalbleitersubstraten spielt die Oxidation der Bondseiten der zu bondenden Substrate eine wesentliche Rolle, da diese den Bondprozess erschwert. Das Oxid verhindert bzw. reduziert die Ausbildung eines mechanisch und/oder eines elektrisch hochwertigen Kontakts. Damit verbunden ist insbesondere, auf Grund langer Hochheiz- und Abkühlzeiten, eine Durchsatzverschlechterung und je höher die Temperatur beim Bonden ist oder sein muss, desto größer sind die Einflüsse der Ausdehnung durch Temperaturunterschiede auf die Ausrichtung beziehungsweise Justiergenauigkeit der Substrate zueinander. Weiters erlauben beispielsweise gewisse MEMS- und/oder Halbleiterbaugruppen, wie beispielsweise Mikrochips oder Speicherbausteine, keine hohen Prozesstemperaturen.

Druckschrift US 2009/286382 A1 offenbart ein Verfahren zum Bonden eines Substrats aus einem Halbleitermaterial mit einem Substrat aus einem metallischen Material. Druckschrift US 2011/207291 offenbart ein Verfahren zum Bonden von Wafern.

Im Stand der Technik werden vor allem Nassätzprozesse zum Entfernen von Oxiden verwendet, die sich auf den genannten Substraten bilden und somit eine optimale Verbindung mehrere Substrate durch einen Bondprozess verhindern oder zumindest erschweren. In den Nassätzprozessen werden vorwiegend Flusssäure oder flusssäurehaltige Mischungen verwendet. Nach der Reduktion des Oxids entsteht eine durch Wasserstoffatome terminierte Oberfläche. Diese hydrophoben Oberflächen eignen sich zur Herstellung eines sogenannten Vorbonds (engl.: pre-bonds). Sollen die beiden Wafer allerdings permanent miteinander verbunden werden, so muss der Waferstapel bei erhöhten Temperaturen wärmebehandelt werden, damit der, durch den Reduktionsprozess entstandene und die Oberfläche des Substrats terminierende, Wasserstoff aus dem Bondinterface entfernt wird und sich eine permanente Verbindung zwischen den beiden Substratoberflächen, insbesondere Siliziumoberflächen, einstellen kann. Der Substratstapel wird nach dem Kontaktieren der Oberflächen wärmebehandelt. Siliziumwafer werden beispielsweise bei einer Temperatur von ungefähr 700°C wärmebehandelt um eine solche permanente Verbindung zu gewährleisten. Die gattungsgemäßen Verfahren dienen insbesondere zur Herstellung von mehrschichtigen Metall-, Halbleiter-, Glas- oder Karamikverbunden. Eine besonders wichtige Anwendung betrifft die Herstellung von photovoltaischen Mehrschichtzellen und photonischen Kristallen, insbesondere photonischen Kristallen aus Silizium.

Eine der Hauptlimitierungen in der Herstellung von Mehrschichtzellen ist die Inkompatibilität der Gitterstrukturen der einzelnen Halbleitermaterialien hinsichtlich ihrer Dimension und Form. Dies führt bei der Herstellung der einzelnen Schichten durch direktes Aufwachsen der Schichten aufeinander zu Defekten in der damit realisierten Halbleiterschicht. Diese Defekte beeinträchtigen die Qualität der erzeugten Schicht und insbesondere dem erzielbaren Wirkungsgrad für die Umwandlung von Licht in elektrische Energie. Dieser Wirkungsgrad wird auch als Quantenausbeute (engl.: quantum efficiency) bezeichnet und definiert für Solarzellen das Verhältnis der, durch den Photoprozess verwendbaren, Ladungsträgern zur Anzahl der absorbierten Photonen einer gewissen Wellenlänge. Daraus resultieren in der Praxis Einschränkungen hinsichtlich folgender Parameter:
a) Anzahl der realisierbaren aktiven Schichten im Aufbau. Dies ist aufgrund der oben beschriebenen Problematik heute auf zwei bis maximal drei Schichten begrenzt.
b) Optimierung der einzelnen Schichten hinsichtlich eines optimalen Wellenlängenbereichs. In der Praxis ist es heute nicht möglich, die einzelnen Schichten völlig frei hinsichtlich dem optimalen Wellenlängenbereich und damit assoziierten Umwandlungscharakteristiken für die Umwandlung von Licht in elektrische Energie zu optimieren, da immer hinsichtlich Kompatibilität der Gitterstruktur Kompromisse eingegangen werden müssen.
c) Einsatz günstigerer Materialien: Für bestimmte Wellenlängen wäre es wünschenswert, beispielsweise Silizium oder Germanium einzusetzen, da diese Materialien einen idealen Kompromiss zwischen Wirkungsgrad und Kosten erlauben würden. Häufig ist der Einsatz dieser Materialien jedoch nicht möglich, da die Gitterstruktur nicht ausreichend kompatibel mit den anderen, in der Zelle verwendeten Strukturen ist.

Eine Oxidbehandlung, im Speziellen die Oxidentfernung, vor einem anschließenden Bondvorgang erfolgt häufig mit Flusssäure. Dabei kann es nach der Oxidentfernung zu einer Kontamination der Oberflächen und insbesondere einem Nachwachsen des Oxides kommen.

Ein weiteres Problem in diesem Zusammenhang ist auch, dass eine unterschiedliche Wartezeit zwischen Oxidentfernung und der Weiterverarbeitung der Substrate zu einem unterschiedlichen Prozessergebnis des verbondeten Substratstapels führt.

Ein weiterer Nachteil bisheriger Verfahren besteht darin, dass Ätzprozesse auf das zu ätzende Oxid abgestimmt werden müssen. Daher sind für verschiedene Halbleitermaterialien unter Umständen auch unterschiedliche Ätzchemikalien notwendig.

Des Weiteren sind unter Umständen auch die Prozessanforderungen hinsichtlich Wartezeit bis zur Weiterverarbeitung, Art der Prozessumgebungsbedingungen (bspw. inerte Atmosphäre, frei von O2 und ggf. auch frei von Wasser) je nach Material unterschiedlich. Aus diesem Grund kann eine Bondinganlage für das Verbonden unterschiedlicher Substrate, bestehend aus verschiedenen Materialien, sehr komplex ausfallen. Zusätzlich kann aufgrund der unterschiedlichen Anforderungen aufgrund verschiedener Materialien auch ein erheblicher Prozessentwicklungsaufwand entstehen, sobald neue Materialien in die Fertigung eingeführt werden sollen.

Eine weitere Möglichkeit der Oxidentfernung stellen, neben den bereits genannten chemischen Prozessen, die physikalischen Prozesse dar. Einer der wichtigsten physikalischen Prozesse zur Oxidentfernung ist das Sputtern. Unter Sputtern versteht man die Abtragung von Atomen an der Oberfläche eines Substrats durch Stoßprozesse ionisierter und durch elektrische und/oder magnetische Felder beschleunigter Atome eines ionisierten Sputtergases.

Beim Sputtern besteht allerdings der Nachteil, dass der Prozess inhärent Partikel erzeugt, da es in der Natur des Prozesses liegt, Material mittels eines physikalischen Prozesses von der Oberfläche zu entfernen. Dieses Material kann sich in der Prozesskammer an verschiedensten Stellen ablagern und entweder durch Sublimation von diesen Stellen auf dem zu verbondenden Substrat abgeschieden werden oder direkt wieder auf dem Substrat resublimiert werden. Diese Partikel sind für ein optimales, sprich void-freies Bondergebnis hinderlich. Weiterhin werden für Sputterprozesse sehr hohe Ionenenergien benötigt, um Materie von der Oberfläche des Substrates entfernen zu können. Dies führt dazu, dass Ionen teilweise in das Substrat implantiert werden und die Schicht nahe der Oberfläche dadurch geschädigt wird. Diese beschädigte Schicht kann in der Regel mehrere nm, typischerweise sogar 5 bis 10nm und dicker sein. Diese Beschädigungen können sich jedoch negativ auf die Charakteristik der Bondverbindung hinsichtlich elektrischer und optischer Parameter auswirken, so dass diese Beschädigungen unerwünscht sind und in der Praxis ein Problem darstellen.

Ein weiteres fundamentales Problem bei der Herstellung von Mehrschichtzellen stellt die, für viele Prozesse typische, Wärmebehandlung dar. Die Wärmebehandlung wird bei Temperaturen zwischen 100 °C und 700 °C durchgeführt. Bei derart hohen Temperaturen werden die verwendeten Werkstoffe mechanisch stark belastet. Die mechanische Belastung wird bei hohen Temperaturunterschieden vor allem durch die thermischen Spannungen bestimmt. Die thermischen Spannungen sind abhängig vom thermischen Ausdehnungskoeffizienten und der Temperaturdifferenz. Können sich die Werkstoffe zueinander nicht frei ausdehnen, da sie entlang eines Bondinterfaces miteinander verschweißt wurden, hat ein Unterschied in den thermischen Ausdehnungskoeffizienten bei einer Temperaturdifferenz entsprechend hohen thermischen Spannungen zur Folge. Da die Werkstoffwahl sehr oft durch andere Randbedingungen vorgegeben wird, können die thermischen Spannungen nur dadurch vermieden werden, dass die Temperaturdifferenzen innerhalb der Prozessschritte möglichst klein sind.

Hier ist noch zu erwähnen, dass gerade die Materialkombinationen, bei denen der Bonding-Prozess den größten Vorteil bieten soll, da eine Integration von Materialien mit unterschiedlichen Gitterparametern und/oder unterschiedlichem thermischen Ausdehnungskoeffizienten erfolgen soll, am wenigsten mit einem Wärmebehandlungsprozess kompatibel sind, da gerade hier zumeist die größten Unterschiede hinsichtlich thermischer Dehnung auftreten.

Aufgabe der vorliegenden Erfindung ist es daher, ein Verfahren zum Bonden anzugeben, mit dem der Bondvorgang effizienter und qualitativ hochwertiger durchgeführt werden kann.

Diese Aufgabe wird mit den Merkmalen des Anspruchs 1 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart und in beliebiger Kombination beanspruchbar sein.

Die vorliegende Erfindung beschreibt eine Methode zur Plasmabehandlung einer Oxidschicht eines Substrats. Die Plasmabehandlung führt dabei erfindungsgemäß zu einer partiellen Abtragung und/oder einer Änderung der Stöchiometrie der Oxidschicht.

Die Erfindung ermöglicht dabei insbesondere die in-situ Bearbeitung der Oxidschicht in einer Plasmakammer, wobei das Plasma aus mindestens einem reduzierenden Gas, insbesondere Wasserstoff, besteht.

Durch das erfindungsgemäße Verfahren ist es möglich, die Behandlung des Oxids sowie den nachfolgenden Bondvorgang vollständig in einem, gegen die Atmosphäre abgedichteten, Arbeitsraum bzw. in, an den Arbeitsraum angeschlossenen, Modulen durchzuführen, sodass eine erneute Oxidation der Oberfläche nach der Behandlung des Oxids verhindert wird.

Die Erfindung beschreibt ein Verfahren das ermöglicht:
(1) mehrere Substrate mit einer gezielt modifizierten Oxidschicht in einer Plasmakammer mittels Reduktionsgas herzustellen,
(2) die Substrate in einer Vakuumumgebung, insbesondere einer Hochvakuumumgebung zu einem Bondmodul zu transportieren und
(3) die Substrate in dem Bondmodul miteinander zu verbonden.

Unter Modifizierung wird erfindungsgemäß verstanden:
- Veränderung der Stöchiometrie des Oxids während und/oder nach der Abscheidung vorzugsweise mit einem
- Abtragen einer gewissen Menge, einer bereits vorhandenen Oxidschicht, bis zu einer gewünschten, neuen Oxidschichtdicke oder
- Amorphisierung der Oxidschicht.

Dies wird mittels einer Vorrichtung realisiert, welche es ermöglicht, die Substrate einem Plasma auszusetzen, welches ein reduzierendes Gas enthält. Insbesondere findet H₂ in Mischung mit zumindest einem zweiten, insbesondere inerten Gas Verwendung. Als bevorzugte Variante hat sich die Verwendung von H₂/Ar Mischungen herausgestellt.

Das Gasgemisch H₂/Ar ist auf Grund des Massenverhältnisses zwischen Argon und Sauerstoff optimal. Die Argonatome, die um einiges schwerer sind als Sauerstoff, werden durch das Plasma ionisiert, auf das zu reduzierende Oxid beschleunigt und brechen es physikalisch, insbesondere mechanisch, durch die kinetische Energie auf. Der dadurch frei werdende Sauerstoff wird dann von den Wasserstoffmolekülen, den Wasserstoffionen oder den Wasserstoffradikalen entsprechend eingefangen. Das dadurch erzeugte, thermodynamisch relativ stabile Wasser wird dann von der Oberfläche abgeführt um eine Rückreaktion zum Metalloxid zu verhindern. Helium eignet sich auf Grund seiner eher geringen Masse nicht. Das Neonatom ist zwar massereicher als das Sauerstoffatom, allerdings nur unwesentlich. Krypton und alle weiteren Edelgase sind zu teuer und zu selten und lohnen sich daher wirtschaftlich eher nicht zum Oxidbrechen. Weitere erfindungsgemäß reduzierende Gase wären insbesondere:
- Stickoxide und/oder
- Kohlenmonoxid und/oder
- Methan und/oder
- Wasserstoff und/oder
- Essigsäuredampf und/oder
- Zitronensäuredampf.

Als Intertgase finden insbesondere Verwendung:
- Xenon und/oder
- Argon und/oder
- Helium und/oder
- Stickstoff und/oder
- Kohlendioxid.

Die Substrate werden in der Prozesskammer, insbesondere in Vakuum, dem Plasma ausgesetzt. Dadurch kommt es zu einer Modifikation der Oxidschicht. Die Modifikation findet durch eine Änderung der Stöchiometrie des Oxids statt, vorzugsweise mit einer Abtragung der Oxidschichtdicke auf einen gezielten und gewünschten Wert oder durch eine Amorphisierung.

Die Ionenenergien des Plasmas sind kleiner als 1000 eV, mit Vorzug kleiner als 500 eV, mit größerem Vorzug kleiner als 250 eV, mit größtem Vorzug kleiner als 150 eV, mit allergrößtem Vorzug zwischen 30 eV bis 150 eV.

In weiterer Folge werden die Substrate entweder in demselben oder bevorzugt in einem eigenen, dafür speziell konfigurierten Bondmodul zueinander ausgerichtet und miteinander in Kontakt gebracht. Dabei kommt es zum Verbonden der Substrate. Dies kann optional durch das Anlegen einer Kraft weiter begünstigt werden, um sicherzustellen, dass die Substrate über die gesamte Fläche verlässlich in Kontakt kommen. Der Transfer zwischen dem Plasmamodul und dem Bondmodul erfolgt dabei in einer Hochvakuumumgebung durch eine Bewegungseinrichtung. Bevorzugt werden die Substrate dabei mittels eines Roboters transportiert.

Erfindungsgemäß kann entweder nur die Oberfläche eines Substrats oder die Oberflächen beider Substrate behandelt werden, bevor der Bondvorgang beider Substrate erfolgt.

### Vorteile der Erfindung

- Schnell,
- Universell für viele verschiedene Substratmaterialien und Oxidtypen einsetzbar,
- Wiederholbare Prozessergebnisse,
- Hohe Qualität des Ergebnisses aufgrund der Prozessführung in Hochvakuum, welches eine Kontamination der Oberflächen verhindert,
- Umweltfreundlich,
- Kostengünstig,
- Keine Abfallprodukte, die entsorgt werden müssten und
- Idealerweise keine bzw. nur eine geringe oder zumindest eine präzise einstellbare Schädigung der Substratoberfläche aufgrund Implantierens.

Der erfindungsgemäße Gedanke besteht in der Behandlung, insbesondere in der gezielten Einstellung der Stöchiometrie, von Oxiden durch reduzierende Gase und/oder Gasgemische in Plasmaanlagen und/oder der Amorphisierung des Oxids, zumindest in einer Oberflächennahen Region. Erfindungsgemäß werden daher atomare und/oder molekulare Gase verwendet.

Grundsätzlich basiert die Erfindung auf der Behandlung der Substrate in einer reduzierenden Atmosphäre eines Plasmas. Hierzu sind grundsätzlich alle Atmosphären denkbar, die mindestens aus einem Gas bestehen, welches geeignet ist, eine Oxidreduktion des an der Bondseite vorhandenen Oxids zu bewirken.

Aufgrund der Verfügbarkeit und der attraktiven Kosten ist erfindungsgemäß die Verwendung von H₂ bevorzugt. Es ist in der Literatur bekannt, dass Oxide auf Halbleitersubstraten mittels H₂ reduziert werden können. Dafür wird in der Regel jedoch eine sehr hohe Temperatur (>600°C) benötigt. Dies ist für eine Vielzahl von Substraten, insbesondere komplexen Verbindungshalbleiter-Substraten nicht akzeptabel, da es dabei im schlimmsten Fall zu einer Zersetzung des Materials (z.B. GaAs zerfällt bei 400°C) oder zumindest zu einer Veränderung des Schichtaufbaus aufgrund Diffusionsprozessen kommen würde. Daher besteht ein wesentlicher Erfindungsaspekt darin, den Prozess so zu gestalten, dass die Oxidreduktion bei niedrigen Temperaturen, am besten bei weniger als 200°C, mit Vorzug weniger als 150°C, noch bevorzugter weniger als 100°C am bevorzugtesten bei Raumtemperatur erfolgen kann.

Um dies zu ermöglichen, wird aus der ausgewählten Atmosphäre ein Plasma gezündet. Aufgrund der Ionenenergien der im Plasma erzeugten und am Substrat auftreffenden Ionen wird ausreichend Energie zugeführt bzw. zur Verfügung gestellt, so dass die Reaktion bei sehr niedrigen Temperaturen, bevorzugt Raumtemperatur, stattfinden kann und/oder eine Amorphisierung des Oxids stattfindet. Somit können Materialien hinsichtlich der thermischen Belastung sehr schonend bearbeitet werden.

Mittels Parametereinstellungen lässt sich mit derselben Grundidee eine Vielzahl verschiedener Substrate bearbeiten, ohne die Basischemie wechseln zu müssen. Bevorzugt lässt sich die Gasmischung aus zwei oder mehreren Gasen mittels eines Gasmischsystems, welches Teil des Gasversorgungssystems für die Prozesskammer ist, rezeptabhängig einstellen und so auf verschiedene Substrate anpassen.

Grundsätzlich ist für die Durchführung des Prozesses jede Art von Plasmakammer denkbar. Dies beinhaltet CCP Kammern (engl. "capcitively coupled plasma", kapazitiv gekoppelte Plasma Kammern), ICP Kammern (engl. "inductively coupled plasma", induktiv gekoppelte Plasma Kammern), sowie Remoteplasmakammern.

Erfindungsgemäß bevorzugt sind jedoch CCP Kammern aufgrund des einfachen Aufbaus und der hohen Produktivität. Der Abstand zwischen den Elektroden beträgt mehr als 2 mm, bevorzugt mehr als 6 mm, mit größerem Vorzug mehr als 9 mm, mit größtem Vorzug mehr als 12 mm mit allergrößtem Vorzug mehr als 16 mm. Dabei ist es erfindungsgemäß insbesondere vorgesehen, dass die untere Elektrode gleichzeitig als Substrathalter ausgeführt ist. Dieser Substrathalter kann gleichzeitig auch als Vakuumprobenhalter, alternativ und bevorzugter als elektrostatischer Probenhalter, ausgeführt sein. Des Weiteren ist denkbar, dass Heiz- und/oder Kühlelemente eingebaut sind, die eine (moderate) Temperaturänderung des Substrats erlauben.

Die Frequenz der angelegten Wechselspannung an der oberen Elektrode ist mit Vorzug größer als die Frequenz der angelegten Wechselspannung an der unteren Elektrode. Bevorzugt besteht zwischen den Frequenzen ein Unterschied um mindestens Faktor 10, noch bevorzugter um mindestens Faktor 100, noch bevorzugter mindestens um Faktor 250. Damit lässt sich ein wechselseitiger Einfluss der Frequenzen aufeinander reduzieren. Die obere Frequenz könnte insbesondere 13,56 MHz oder 27 MHz betragen während die Frequenz, mit der die untere Elektrode beaufschlagt wird insbesondere 40 kHz, 100 kHz oder 400kHz betragen könnte. In dieser Anordnung führt die obere Frequenz überwiegend zu einer Ionisierung der Atmosphäre während die untere Frequenz zum Beschleunigen der Ionen auf die Substratoberfläche führt. Somit lassen sich die Dichte des Plasmas und die Ionenenergie, mit der die Ionen auf das Substrat auftreffen, getrennt einstellen. Dies ist vorteilhaft, da damit der Prozess besser kontrollierbar wird, da damit Ionendichte und Ionenenergie erfindungsgemäß separat und unabhängig voneinander einstellbar sind.

In einer bevorzugten Ausführungsform für die Oxidreduktion von Si Wafern beträgt die Frequenz der Wechselspannung der oberen Elektrode 13,56 MHz und die Frequenz der Wechselspannung der unteren Elektrode 80 kHz bis 120 kHz. Die Leistung für die obere und untere Elektrode liegt insbesondere bei 50 W bis 500 W. Als Gasgemisch findet vorzugsweise eine Mischung aus H₂/Ar Einsatz, deren Konzentrationswerte zwischen 100% H₂/0%Ar und 0%H₂/100%Ar liegen und insbesondere keine nennenswerten weiteren Bestandteile über 1 % aufweisen. Bevorzugter liegt die Konzentration unter 80%/ H₂, noch bevorzugter unter 60%H₂, am bevorzugtesten unter 40%H₂, am meisten bevorzugt unter 20%H₂..

Die Zufuhr des Gases erfolgt gleichmäßig über dem Umfang der Plasmakammer verteilt, um ein gleichmäßiges Prozessergebnis zu gewährleisten. Ebenso erfolgt das Absaugen des Gases aus der Plasmakammer in einer gleichmäßigen Form, insbesondere durch am Umfang verteilte Ausgänge. Während des Plasmabehandlungsprozesses wird die Kammer kontinuierlich mit der Gasmischung durchströmt, um die bei der Reduktion entstehenden Reaktionsprodukte, insbesondere H₂O, aus der Kammer abzutransportieren. Dies ist entscheidend, da es für eine bessere Oxidreduktion insbesondere vorgesehen ist, dass eine höhere Anzahl an Reduktionsreaktionen stattfindet als ein erneutes Oxidieren von Si mit H₂O. Um die Gleichmäßigkeit der Reaktion über den Wafer zu gewährleisten, ist es insbesondere vorgesehen, für eine gleichmäßige Gasströmung in der Kammer während des Prozesses und daraus folgend eine gleichmäßige Konzentration des Prozessgases zu sorgen.

Die Ionenenergie, mit der die Teilchen auf der Oberfläche des Substrats auftreffen, wird hauptsächlich über die untere Elektrode gesteuert. Diese Energie beeinflusst einerseits die erfolgreiche Behandlung des Oxids an der Substratoberfläche und ist andererseits so gering gewählt, dass es nur zu einer minimalen Implantierung der Substratoberfläche und einer damit einhergehenden Schädigung kommt.

Andererseits kann es jedoch gewünscht sein, eine einstellbare und kontrollierte Schädigung der Substratoberfläche zu erzeugen, um eine Schicht zu erzeugen, die eine geringere mechanische Festigkeit aufweist. Dies ermöglicht mit Vorteil ein Schließen von Nano-Lücken zwischen den Oberflächen nach dem Kontaktieren der Substrate mittels Verpressen basierend auf einer hohen Anpresskraft. Der Druck auf die Oberfläche liegt zwischen 0.01 MPa und 10 MPa, mit Vorzug zwischen 0.1 MPa und 8 MPa, mit größerem Vorzug zwischen 1 MPa und 5 MPa, mit größtem Vorzug zwischen 1.5 MPa und 3 MPa. Diese Werte entsprechen ungefähr einer Kraftbeaufschlagung von 1 kN bis 320 kN für ein gängiges 200 mm Substrat. Mit dieser kontrollieren Schädigung wird erfindungsgemäß vorzugsweise eine Amorphisierung des Oxids oder zumindest der oberflächennahen Oxidbereiche. Die Amorphisierung der Oberfläche erfolgt vorzugsweise über die Einstellung der Ionenenergie. Der amorphe Bereich kann die gesamte Oxidschicht umfassen, ist vorzugsweise allerdings auf eine oberflächennahe Region beschränkt. Die Dicke der amorphen Schicht ist dabei insbesondere kleiner als 10nm, mit Vorzug kleiner als 5 nm, mit größerem Vorzug kleiner als 1 nm, am bevorzugtesten kleiner als 0.1nm.

Mit Vorzug ist es dabei denkbar, während dem Prozessverlauf zuerst mit einer für die Oxidreduktion optimierten Gasmischung den Prozess zu starten und nach erfolgter Oxidreduktion die Gasmischung zu variieren und auf eine Mischung umzustellen, die für eine gezielte Oberflächenschädigung optimiert ist. Dies kann dynamisch währen des Prozesses erfolgen und durch eine, insbesondere softwaregestützte, Steuereinrichtung bewirkt werden.

Der Wechsel der Gasmischung kann auch mit einer Anpassung der Einstellung der Frequenzgeneratoren für die untere und/oder obere Elektrode einhergehen. So kann mit Vorzug die Leistung der unteren und/oder oberen Frequenzgeneratoren angepasst werden, Spannungs- und Stromgrenzwerte für die Generatoren verändert werden, sowie Frequenzen geändert werden. Dies kann wiederum dynamisch, bewirkt von der Steuereinrichtung bewirkt werden. Mittels dieser Parameter kann die Dicke der geschädigten Schicht, die Dichte der Schädigung und ggf. die Spezies bzw. Dosis implantierter Ionen eingestellt werden.

Die Schädigung geht daher meistens auch mit einer Amorphisierung der oberflächennahen Bereiche einher.

Im Falle von Halbleitersubstraten, von denen das Oxid entfernt wird (ist kein Gegenstand der Erfindung), wird durch die Reduktion in der Regel der darunter liegende, monokristalline oder zumindest kristalline (mit wenigen Defekten, bspw. Wachstumsdefekten aufgrund MO CVD) Halbleiterwafer freigelegt.

Ein typischer Prozessablauf würde also aus dem Laden eines Substrates in eine Plasmakammer für eine Modifizierung mindestens einer der Bondschichten, insbesondere einer Oxidreduktion, einem Oxidreduktionsprozess und optional einem Prozess zur gezielten Modifikation / Schädigung der obersten Schicht der Substrate bestehen.

Weiterhin werden die Substrate im Arbeitsraum in Hochvakuum-Umgebung zu einer Bondkammer transportiert, dort zueinander mechanisch und / oder optisch ausgerichtet und in Kontakt gebracht. Optional werden sie auch mit einer (hohen) Kraft beaufschlagt und miteinander verpresst. Anschließend können die Substrate entladen werden. Die Bondkammer kann erfindungsgemäß identisch mit der Plasmakammer sein, also als Bondplasmakammer.

Die Hochvakuum-Umgebung weist erfindungsgemäß insbesondere einen Druck von weniger als 1x10⁻⁵ mbar, besser 5x10⁻⁶ mbar, noch besser 1x10⁻⁶ mbar, am besten 5x10⁻⁷ mbar, am allerbesten 9x10⁻⁸ mbar auf.

In einer weiteren Ausführungsform werden die erfindungsgemäßen Reduktionsprozesse nicht zur vollständigen Entfernung der Oxide verwendet, sondern dienen der Einstellung einer korrekten Stöchiometrie der Oxide. Insbesondere können damit Schichten erzeugt werden, die einen Überschuss an dem bzw. an den Elementen aufweisen, die an den Sauerstoff binden. Beispielsweise befindet sich Siliziumoxid dann nicht mehr in der stöchiometrisch korrekten Form als SiO₂, sondern als nicht stöchiometrisches SiO₂₋ₓ vor. Im Allgemeinen entstehen also beispielsweise nichtstöchiometrische Zusammensetzungen SiO₂₋ₓ, mit x zwischen 0 und 2. Analoge Überlegungen gelten für andere Oxide. Die Nichtstöchiometrie ist kristallphysikalisch durch ein Fehlen der Sauerstoffatome an ihren Positionen im Kristallgitter zu verstehen. Durch das Fehlen der Sauerstoffatome erhöht sich die Fehlstellendichte. Die Fehlstellen wiederum sind von entscheidender Bedeutung für jede Art von Transportprozessen.

In einer weiteren Ausführungsform werden die erfindungsgemäßen Reduktionsprozesse nicht zur vollständigen Entfernung der Oxide verwendet, sondern dienen zur Herstellung einer Oxidschicht mit definierter Schichtdicke. Dabei werden bereits vorhandene Oxidschichten durch die erfindungsgemäßen Reduktionsprozesse auf eine gewünschte Schichtdicke abgetragen. Die so erzeugten Schichten können dann beispielsweise für die in den Patenten PCT/EP2011/000299, PCT/EP2011/055470, PCT/EP2011/055469, PCT/EP2011/055471 offenbarten Prozesse verwendet werden. Erfindungsgemäß sind die Oxide vor dem Abtragungsprozess größer als 1nm, mit Vorzug größer als 100nm, mit größerem Vorzug größer als 10µm, mit größtem Vorzug größer als 100µm, mit allergrößtem Vorzug größer als 1000µm. Nach dem Abtragungsprozess sind die Oxide mit Vorzug kleiner als 100µm, mit Vorzug kleiner als 10µm, mit größerem Vorzug kleiner als 100nm, mit größtem Vorzug kleiner als 10nm, mit allergrößtem Vorzug kleiner als 1 nm.

Die gezielte Modifikation einer Oxidschicht dient vor allem auch der Herstellung eines optimaleren Hybridbonds. Ein Hybridbond ist eine Verbindung zwischen zwei Oberflächen, die wiederum aus leitfähigen und nichtleitfähigen Regionen bestehen. Bei den leitfähigen Regionen handelt es sich vorwiegend um metallische Bereiche, insbesondere aus Kupfer, wohingegen die nichtleitenden Bereiche vorwiegend aus einem Dielektrikum wie Siliziumoxid bestehen. Die dielektrischen und elektrischen Bereiche sind insbesondere auf das gleiche Niveau zurückgeschliffen, sodass die elektrischen Bereiche vollständig von einem Dielektrikum umgeben und damit von der Umgebung isoliert sind. Durch die Ausrichtung, das Kontaktieren und das Verbonden zweier solcher Hybridoberflächen erfolgt die Ausbildung eines Hybridbonds, daher einer Verbindung zwischen zwei Substraten, bei denen vorzugsweise die leitenden und die nichtleitenden Regionen miteinander verbondet werden.

Erfindungsgemäße Substrate sind insbesondere Si-Substrate, bei welchen Cu-Cu Bonds an den Bondseiten vorhanden sind, welche im weiteren Verlauf eines Prozesses gebondet werden. Alternativ können erfindungsgemäß Substrate mit anderen Metallschichten wie beispielsweise aus Au, W, Ni, Pd, Pt, Sn etc. oder einer Kombination von Metallen verwendet werden. Beispiele hierfür wären Si-Wafer, welche mit A1 beschichtet sind, Si-Wafer, welche mit Cu und Sn beschichtet sind, Si-Wafer, welche mit Ti beschichtet sind oder Si Substrate welche mit Cu und einer industrieüblichen, unter dem Cu liegenden und dem Fachmann bekannten Sperrschicht, beispielsweise aus Ti, Ta, W, TiN, TaN, TiW etc., welche das Eindiffundieren von Cu in das Si verhindern soll, beschichtet sind. Derartige Diffusionsbarrieren sind dem Fachmann auf dem Gebiet bekannt.

Erfindungsgemäß ist es demnach entscheidend, einen von der Umgebung, also einer oxidierenden Atmosphäre, insbesondere dichtend, vorzugsweise hermetisch, abschließbaren Arbeitsraum und entsprechende daran angeschlossene Module vorzusehen, in welchen sowohl eine Reduktion etwaiger Oxidschichten auf den Bondseiten, vorzugsweise dem gesamten Substrat, als auch das Bonden durchführbar ist. Somit kann erfindungsgemäß verhindert werden, dass zwischen einer Reduktion und dem Bondprozess eine erneute Oxidation der Bondseiten stattfindet. Je nach Beschaffenheit der Substrate, insbesondere der auf den Substraten vorhandenen Metallbeschichtung können verschiedene Bestandteile einer Atmosphäre oxidierend wirken. Zumeist haben jedoch Sauerstoff und chemische Verbindungen, die Sauerstoff enthalten, eine oxidierende Wirkung. Insbesondere soll daher im Arbeitsraum neben der Verwendung einer reduzierenden Medienzusammensetzung die Konzentration von Sauerstoff und Wasser/Wasserdampf stark reduziert oder bevorzugt annähernd Null sein. Der Arbeitsraum verbindet mehrere Module, sodass ein Transport von Substraten zwischen den Modulen der Modulgruppe möglich ist, ohne die Substrate wieder der Atmosphäre auszusetzen. Denkbar sind auch Ausführungsformen, bei denen nur ein Modul an den Arbeitsraum angeschlossen wird, das allerdings erfindungsgemäß alle notwendigen Arbeiten verrichten kann. Der Arbeitsraum dient in diesem Fall ausschließlich der Lade- und Entladetätigkeit.

Erfindungsgemäß ist es insbesondere denkbar, zur weiteren Prozessoptimierung zusätzliche Module an den Arbeitsraum anzuschließen, insbesondere zur Vor- und/oder Nachbehandlung und/oder der Messung der physikalischen und/oder chemischen Eigenschaften der zu bondenden Substrate im Arbeitsraum. Wesentliche Verfahrensschritte können dabei Heizen, Reduzieren, Ausrichten (Alignment), Kühlen, Schichtdickenmessung, Bondstärkenmessung etc. sein.

Besonders vorteilhaft lässt sich dies vorrichtungsgemäß umsetzen, wenn um den Arbeitsraum, insbesondere die Bewegungseinrichtung umfassend, weitere erfindungsgemäße Module wie insbesondere das Reduktionsmodul und das Bondmodul angeordnet sind, wobei diese insbesondere an den Arbeitsraum andockbar sind. Bei der Bewegungseinrichtung handelt es sich mit Vorzug um einen handelsüblichen Industrieroboter mit entsprechendem End-Effektor. Dabei können die Module insbesondere sternförmig oder clusterförmig um das Zentralmodul angeordnet oder anordenbar sein.

Im idealsten Fall sind das Reduktionsmodul und das Bondmodul so aufgebaut, dass der Durchsatz der gesamten Anlage bezüglich dieser Prozessschritte maximiert wird.

In einer besonders vorteilhaften Ausführung wären dem Bondmodul mindestens zwei Module vorgelagert, wovon eines mindestens ein Reduktionsmodul ist und das zweite eine Art Speichermodul. Die Bondchucks werden mit den geladenen Wafern in das Reduktionsmodul geladen und behandelt. Danach können die Bondchucks im Speichermodul zwischengelagert werden und stehen jederzeit für den sofortigen Bondeinsatz zur Verfügung. In einer speziellen Ausführungsform kann auch das Speichermodul als Reduktionsmodul aufgebaut sein. Das Reduktionsmodul ist vorzugsweise so aufgebaut, dass mehrere Bondchucks und/oder mehrere Substrate gleichzeitig aufgenommen werden können.

Ein, insbesondere eigenständiger Aspekt der vorliegenden Erfindung besteht darin, wie diese Schichten in einer elektrisch leitfähigen und optisch transparenten Form mit einem gleichzeitig kostengünstigen Prozess gestapelt werden können. Darüber hinaus wird die, dafür notwenige Vorbereitung der Substrate beschrieben.

Das dabei beschriebene Verfahren eignet sich mit Vorzug für das Stapeln von Mehrschichtsolarzellen. Alternativ kann das Verfahren aber auch zur Erzeugung jeglicher anderer Strukturen und Bauteile eingesetzt werden, bei denen optisch transparente und elektrisch leitfähige Verbindungen zwischen beliebigen (insbesondere optischen) Materialien, insbesondere Halbleitermaterialien, Gläsern und Keramiken notwendig sind. In diesem Segment ergeben sich zunehmend mehr Anwendungen aufgrund der stark steigenden Bedeutung von Festkörper-Lichtquellen wie LEDs und Laser in einer Vielzahl von Anwendungen wie Beleuchtung, Kommunikation, Materialbearbeitung. Auch im Segment der Displayfertigung gewinnen neue, innovative Fertigungstechnologien zunehmend an Bedeutung, da zusätzliche Funktionen wie Berührungsdetektion (Feedback im Bereich von Touch Screens, etc.) in Displays integriert werden sollen.

Vorteile der Erfindung sind vor allem:
- Elektrisch Leitfähiges, optisch transparentes Bonding-Interfaces bzw. Verbindungsschicht,
- Sehr dünne, robuste und langzeit-stabile Bonding-Interfaces bzw. Schicht(en),
- Temperaturbeständige Bonding-Interfaces bzw. Schicht(en) und
- hohe Effizienz (schnell & kostengünstig in der Herstellung).

Ein zentraler, insbesondere eigenständiger Aspekt der vorliegenden Erfindung ist die Nutzung von transparenten, leitfähigen Oxiden zur Herstellung der elektrisch leitfähigen und optisch transparenten Verbindungsschicht zwischen den Substraten. Die Verbindung wird insbesondere mittels Wafer Bonding, bevorzugt mit einem Direktbondverfahren und noch bevorzugter einem Direktbondverfahren mit Plasma-Aktivierung hergestellt.

Als transparente, elektrisch leitfähigen Oxide (auf Englisch auch "Transparent Conductive Oxides" oder kurz "TCO" genannt) wird insbesondere Indium-Zinn-Oxid (Englisch: "Indium-tin-oxide" oder kurz "ITO") eingesetzt. Nachfolgend soll hier die Abkürzung ITO für Indium-Zinn-Oxid verwendet werden. ITO findet breite Anwendung in der Herstellung von LCD Displays, wo es als optisch transparenter elektrischer Leiter zum Einsatz kommt. Alternativ werden folgende Materialen verwendet:
- dotierte Zink-Oxide, insbesondere Aluminium-dotiertes Zink-Oxid (Englisch: "Aluminum doped Zinc Oxide" kurz: "AZO"), Gallium dotiertes Zink-Oxid (Englisch: "Gallium doped Zinc Oxide" kurz: "GZO"),
- Fluor-dotierte Zinn-Oxide (Englisch: "Fluorine Tin Oxide" kurz: "FTO"), sowie
- Antimon-Zinn-Oxid (Englisch: "Antimony Tin Oxide" kurz: "ATO") Grundsätzlich kann jedes Material, das oxidierbar ist, und insbesondere mit entsprechender Dotierung die gewünschten Eigenschaften, insbesondere elektrische Leitfähigkeit und optische Transparenz aufweist, verwendet werden.

Erfindungsgemäß wird in diesem Zusammenhang von elektrischer Leifähigkeit gesprochen, wenn das Material eine Leitfähigkeit von >10el S/cm, bevorzugt von 10e2 S/cm und noch bevorzugter von >10e3 S/cm (gemessen mit der in der Halbleitertechnologie üblichen Vierpunktmethode, bezogen auf eine Temperatur von 300K) verfügt. Die optische Transmission (Transmissionsgrad), definiert als jener Prozentsatz des Lichtes, eines bestimmten Wellenlängenbereiches, der verwendungsgemäß die Schicht passieren soll, soll durch einen Film mit verwendungsgemäßer Dicke mindestens >80%, mit Vorteil >87%, bevorzugt >93% und noch bevorzugter >96% betragen.

Erfindungsgemäß sind Wellenlängenbereiche, die von 300nm bis 1800nm reichen, bevorzugt für Photovoltaikanwendungen. Das heißt, dass der relevante Wellenlängenbereich jedenfalls größer ist als der für Menschen sichtbare Wellenlängenbereich. Dies soll gewährleisten, dass auch der UV Anteil im Licht und der IR Anteil im Licht in elektrische Energie umgewandelt werden können. Da bei einer Mehrschicht-Solarzelle die oberste Schicht bereits einen Teil des Spektrums verarbeitet, und somit in elektrische Energie umwandelt, ist es akzeptabel, wenn die Bondverbindung einen etwas kleineren Wellenlängenbereich aufweist, in dem sie Transmission zulässt. Insbesondere sollen daher die oben genannten Transmissionswerte zumindest für Wellenlängen > 600 nm, mit Vorteil >500 nm und mit größerem Vorteil >400 nm und mit allergrößtem Vorteil >350 nm gelten. Weiters sollen die Transmissionswerte insbesondere auch für den gesamten Wellenlängenbereich ausgehend von der minimalen Wellenlänge bis maximal 1300 nm, mit Vorteil bis maximal 1500 nm, mit größerem Vorteil bis maximal 1700 nm und mit allergrößtem Vorteil bis maximal 1800 nm gelten.

Die Oxide werden erfindungsgemäß insbesondere mittels folgender Verfahren auf die zu verbindenden Substrate aufgebracht:
- MO CVD, Metal Organic Molecular Beam Deposition,
- Spray Pyrolyse, Pulsed Laser Deposition (PLD) oder
- Aufsputtern.

Um die gewünschten Eigenschaften der Schichten zu gewährleisten, ist es erfindungsgemäß kritisch, das richtige Mischungsverhältnis zu gewährleisten. Insbesondere der Anteil von Sauerstoff kann bei einigen dieser Oxide die optische Transparenz verbessern, wobei sichergestellt werden muss, dass der Sauerstoffanteil nicht zu hoch ausfällt, da ansonsten die elektrische Leitfähigkeit reduziert wird.

Generell wird die Bondverbindung (Verbindungsschicht, auch Bonding-Interface) hergestellt, indem auf die zu verbondenden Substrate ein Precursor Schichtaufbau abgeschieden wird. Anschließend werden die Schichten plasmaaktiviert und, insbesondere bei Raumtemperatur, gefügt, wodurch ein Pre-Bond (temporärer Bond) entsteht. Während dem darauf folgenden Wärmebehandlungsprozess (Annealing) wird der Pre-Cursor-Schichtaufbau in eine Schicht bestehend aus transparentem, elektrisch leitfähigem Oxid umgewandelt, wobei gleichzeitig die Bondverbindung gestärkt wird. Besonders vorteilhaft kann sich eine, zumindest in der Oberflächenregion bestehende, amorphe Schicht auf den Bondvorgang auswirken. Durch das Aufbringen einer entsprechenden Kraft kann eine Verformung der oberflächennahen Regionen erfolgen, die ein optimales Verschließen von Mikro- und/oder Nanoporen garantiert.

Bei der Verwendung von Formiergas ist es insbesondere möglich, die Oxidschicht durch einen Prozess, der auf Sputtern und Oxidreduktion beruht, erfindungsgemäß zu verändern, insbesondere gänzlich zu entfernen.

Alternativ oder zusätzlich zu dieser Maßnahme ist es erfindungsgemäß von Vorteil, die Zeit zwischen der Veränderung der Oxidschicht und der Kontaktierung zu minimieren, insbesondere <2 Stunden, vorzugsweise <30 Minuten, noch bevorzugter <15 Minuten, idealerweise <5 Minuten. Damit lässt sich ein ungewünschtes und veränderndes Oxidwachstum, welches nach der gezielten Einstellung der Oxidschicht erfolgt, minimieren.

Durch Einstellung eines bestimmten Drucks in der Vakuumkammer ist eine Einflussnahme beziehungsweise Einstellung der mittleren freien Weglänge für die Plasmaionen erfindungsgemäß denkbar.

Im Falle der kapazitiven Kopplung ist es vorteilhaft, wenn die Elektroden innerhalb der Plasmakammer angeordnet sind.

Dabei wird durch Einstellung der Parameter (unterschiedliche) Frequenzen der Elektroden, Amplituden, einer, insbesondere, vorzugsweise ausschließlich, an der zweiten Elektrode angelegten Biasspannung und Kammerdruck eine optimale Beaufschlagung der Kontaktflächen..

Die Ausführung der Plasmaaktivierungsanlage als kapazitiv gekoppelte Doppelfrequenz-Plasmaanlage ermöglicht mit Vorteil ein getrenntes Einstellen der Ionendichte und der Beschleunigung der Ionen auf die Waferoberfläche. Somit lassen sich erzielbare Prozessergebnisse in einem breiten Fenster einstellen und optimal an die Erfordernisse der Anwendung anpassen.

Die Biasspannung dient, insbesondere in Form einer Grundspannung der zweiten, insbesondere unteren, Elektrode dazu, das Auftreffen (Geschwindigkeit) der Elektroden auf die Kontaktfläche des auf der zweiten Elektrode aufgenommenen Substrats zu beeinflussen, insbesondere zu dämpfen oder zu beschleunigen.

Durch die vorgenannten Parameter wird insbesondere die Qualität der amorphen Schicht einstellbar, wobei nachfolgend besonders vorteilhafte Ausführungsformen beschrieben werden.

Bei einer induktiv gekoppelten Plasmaquelle können entsprechende Analogieüberlegungen über die Wechselspannung der kapazitiven Kopplung auf Wechselströme, die zur Erzeugung eines magnetischen Feldes genutzt werden, übernommen werden. Erfindungsgemäß ist es denkbar, das Plasma der induktiv gekoppelten Plasmaquelle durch einen Wechselstrom bzw. magnetisches Wechselfeld unterschiedlicher Stärke und/oder Frequenz so zu manipulieren, dass das Plasma entsprechende erfindungsgemäße Eigenschaften aufweist.

Bei einem Remoteplasma, wird das eigentlich zu verwendende Plasma in einer externen Quelle erzeugt, und in den Probenraum eingeführt. Insbesondere werden Bestandteile dieses Plasmas, insbesondere Ionen, in den Probenraum transportiert. Der Übergang des Plasmas vom Quellen- in den Substratraum kann durch unterschiedliche Elemente wie Schleusen, Beschleuniger, magnetische und/oder elektrische Linsen, Blenden etc. gewährleistet werden. Alle für das kapazitiv und/oder induktiv gekoppelte Plasma geltenden Überlegungen bezüglich Frequenzen und/oder Stärken der elektrischen und/oder magnetischen Felder soll für sämtliche Elemente, welche die Erzeugung und/oder den Übergang des Plasmas vom Quellen- in den Substratraum gewährleisten gelten. Denkbar wäre beispielsweise, dass ein Plasma durch kapazitive oder induktive Kopplung durch die erfindungsgemäßen Parameter im Quellenraum erzeugt wird und danach über die oben offenbarten Elemente in den Substratraum eindringt.

Gemäß einer weiteren, vorteilhaften Ausführungsform der Erfindung ist vorgesehen, dass die Ausbildung des irreversiblen Bonds bei einer Temperatur von typischerweise weniger als 300°C, mit Vorteil von weniger als 200°C, mit größerem Vorzug weniger als 150°C, mit noch größerem Vorzug weniger als 100°C, mit größtem Vorzug bei Raumtemperatur insbesondere während maximal 12 Tage, bevorzugter maximal 1 Tag, noch bevorzugter maximal 1 Stunde, am bevorzugtesten maximal 15 Minuten, erfolgt. Eine weitere, vorteilhafte Wärmebehandlungsmethode ist die dielektrische Erwärmung durch Mikrowellen.

Dabei ist es besonders vorteilhaft, wenn der irreversible Bond eine Bondstärke von größer 1,5 J/m², insbesondere größer 2 J/m², vorzugsweise größer 2,5 J/m² aufweist.

Die Nutzung der Sonnenenergie mittels Photovoltaik Anlagen gewinnt zunehmend an Bedeutung, da fossile Energieträger mittelfristig knapp werden und außerdem ein erhebliches Umweltproblem in der Gewinnung und der Nutzung, insbesondere durch den Beitrag zum Treibhauseffekt darstellen. Um die Konkurrenzfähigkeit von Photovoltaik aus rein wirtschaftlicher Sicht zu stärken ist es notwendig, den Wirkungsgrad der Umwandlung von Licht in elektrische Energie bei gleichen Kosten oder maximal moderater Kostensteigerung zu verbessern. Dabei sind dem möglichen Wirkungsgrad jedoch Grenzen gesetzt. Diese Grenzen resultieren primär aus der Einschränkung, dass ein einzelnes Halbleitermaterial nur Licht mit einem eingeschränkten Wellenlängenbereich verarbeiten und in elektrische Energie umwandeln kann.

Eine Verwendung der vorliegenden Erfindung für die Herstellung von Mehrschichtsolarzelle oder noch oder unter dem Englischen Ausdruck bekannten "Multi-Junction Solar Cells" ist daher besonders vorteilhaft.

Bei diesen liegen die einzelnen Schichten vertikal übereinander gestapelt in der Solarzelle. Einfallendes Licht trifft zuerst die oberste Schicht, die dafür optimiert ist, Licht mit einem bestimmten, ersten Wellenlängenbereich in elektrische Energie umzuwandeln. Licht mit einem Wellenlängenbereich der weitgehend nicht in dieser Schicht verarbeitet werden kann, durchdringt diese erste Schicht und trifft auf die darunterliegende zweite Schicht, die dafür optimiert ist, einen zweiten Wellenlängenbereich zu verarbeiten und damit elektrische Energie zu produzieren. Optional ist es in diesen Mehrschichtzellen möglich, dass Licht mit einem Wellenlängenbereich, der auch in dieser zweiten Schicht weitgehend nicht verarbeitet werden kann, auf eine darunterliegende dritte Schicht trifft, die dafür optimiert ist, Licht mit einem dritten Wellenlängenbereich zu verarbeiten und in elektrische Energie umzuwandeln. Man kann sich vorstellen, dass rein theoretisch eine Vielzahl (n) solcher Schichten möglich ist. In der Praxis sind derartige Zellen so aufgebaut, dass die oberste Schicht, in das einfallende Licht als erstes eindringt, jenen Wellenlängenbereich mit der kürzesten Wellenlänge verarbeitet. Die zweite Schicht, den nächst kürzeren Wellenlängenbereich und so weiter. Dabei ist erfindungsgemäß nicht nur ein zweischichtiger Aufbaus denkbar sondern drei oder mehr Schichten sind realisierbar. Dabei ist es vorgesehen, die Schichten vertikal elektrisch leitfähig, d.h. mit einem möglichst geringen elektrischen Widerstand und optisch transparent miteinander zu verbinden. Das Abscheiden der Schichten erfolgt dabei insbesondere durch sogenannte "Metalorganic Chemical Vapor Deposition", kurz "MO CVD" Prozesse, wobei das Abscheiden der beiden aktiven Schichten der Mehrfachzelle insbesondere "in-situ", das heißt ohne die Substrate zwischen den Abscheideprozessen der normalen Umgebungsatmosphäre auszusetzen, abgeschieden werden. Mit Vorzug werden zwischen die aktiven Schichten auch Sperrschichten (zweite oder vierte Oxidschicht) und/oder Pufferschichten (zweite oder vierte Oxidschicht) eingebracht, die die Qualität der resultierenden Zelle verbessern.

Soweit vorliegend und/oder in der anschließenden Figurenbeschreibung Vorrichtungsmerkmale offenbart sind, sollen diese auch als Verfahrensmerkmale offenbart gelten und umgekehrt.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1a: eine Querschnittsansicht eines Substrats mit einer Oxidschicht.
- Figur 1b: das Substrat aus Figur la mit einer gemäß einer ersten Ausführungsform der Erfindung durch Plasma modifizierten Oxidschicht,
- Figur 1c: das Substrat aus Figur 1a mit einer gemäß einer zweiten Ausführungsform der Erfindung durch Plasma in der Dicke reduzierten Oxidschicht,
- Figur 1d: das Substrat aus Figur 1a mit einer gemäß einer drittten Ausführungsform, die jedoch nicht zum Gegenstand der Erfindung gehört, durch Plasma vollständig entfernten Oxidschicht,
- Figur 2: eine schematische Darstellung einer ersten Ausführungsform einer Vorrichtung, umfassend eine Bondkammer und einer davon räumlich getrennten Plasmakammer, beide an den Arbeitsraum angeschlossen,
- Figur 3: eine schematische Darstellung einer zweiten Ausführungsform einer Vorrichtung, umfassend eine an den Arbeitsraum angeordneten Bondplasmakammer,
- Figur 4: eine schematische Darstellung einer dritten Ausführungsform einer Vorrichtung, umfassend mehreren Plasmakammern und einer Bondkammer,

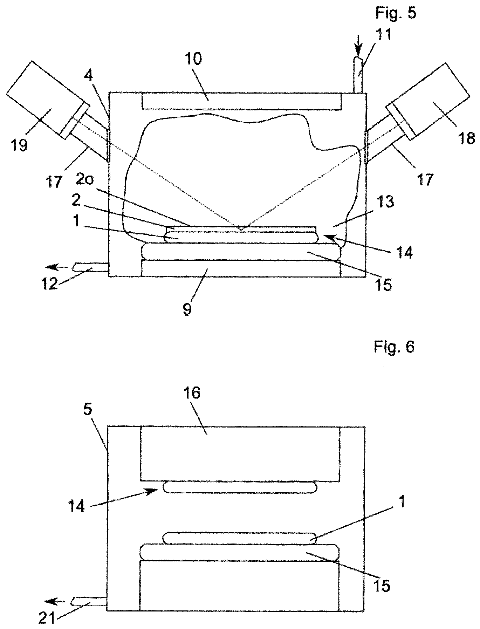

- Figur 5: eine schematische Darstellung einer Plasmakammer und
- Figur 6: eine schematische Darstellung einer Bondkammer.

In den Figuren sind Vorteile und Merkmale der Erfindung mit diese jeweils identifizierenden Bezugszeichen gemäß Ausführungsformen der Erfindung gekennzeichnet, wobei Bauteile beziehungsweise Merkmale mit gleicher oder gleichwirkender Funktion mit identischen Bezugszeichen gekennzeichnet sind.

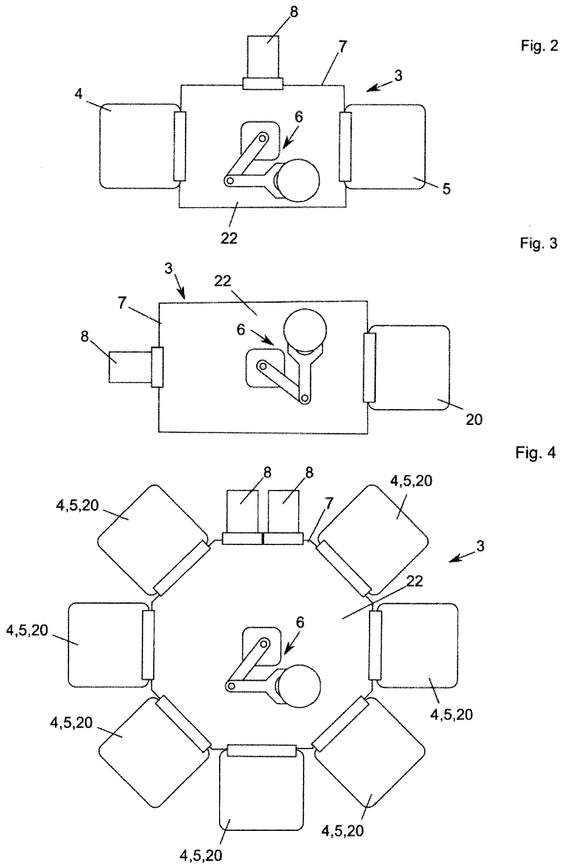

In der in Figur 2 gezeigten ersten Ausführungsform sind eine Plasmakammer 4 und eine Bondkammer 5 zwei eigenständige Module einer Modulgruppe 3, die an einen evakuierbaren, von einer Arbeitskammer 7 definierten Arbeitsraum 22, insbesondere gedichtet, angeschlossen sind. Die Arbeitskammer 7 kann auf ein Hochvakuum evakuiert werden, insbesondere gesteuert durch eine softwaregestützte Steuereinrichtung. Innerhalb der Arbeitskammer 7 transportiert ein eigens dafür vorgesehener Roboter 6 die Substrate 1 zwischen einem Belademodul 8, der Plasmakammer 4 und der Bondkammer 5.

In einer zweiten Ausführungsform sind die Plasmakammer 4 und die Bondkammer 5 in einem einzigen Modul zusammengefasst, nämlich einer Bondplasmakammer 20. Der Roboter 6 transportiert die Substrate 1 vom Vorratsbehälter 8 in die Bondplasmakammer 20.

In einer dritten Ausführungsform sind ein oder mehrere Plasmamodule 4 oder Bondmodule 5 oder Bondplasmamodule 20 der Modulgruppe 3 an der Arbeitskammer 7 angebaut und diese bilden, insbesondere gemeinsam, den Arbeitsraum 22. Der Roboter 6 transportiert die Substrate 1 von dem Vorratsbehälter 8 zu den Plasmamodulen 4 und/oder Bondmodulen 5 und/oder Bondplasmamodule 20, insbesondere auch zwischen diesen hin und her. Dabei werden erfindungsgemäß höhere Durchsätze erzielt, da mehrere Plasmamodule 4 und/oder mehrere Bondmodule 5 und/oder mehrere Bondplasmamodule 20 verwendet werden. Der Vorgang wird gesteuert von der Steuereinrichtung.

In einem erfindungsgemäß ersten Prozess wird ein Substrat 1 mit einer auf einer Bondseite 1o ausgebildeten Oxidschicht 2 (Fig. la) durch den Roboter 6 aus dem Vorratsbehälter 8 entnommen.

Das Substrat 1 kann auf einem mobilen Probenhalter montiert werden und so zwischen den Plasmamodulen 4 und/oder den Bondmodulen 5 und/oder den Bondplasmamodulen 20 hin und her transportiert werden. Der Transport der Substrate 1 ist allerdings auch ohne den mobilen Probenhalter möglich. In diesem Fall werden die Substrate 1 auf Probenhalter 15 gelegt, die sich bereits in den Plasmamodulen 4 und/oder den Bondingmodulen 5 und/oder den Bondingplasmamodulen 20 befinden, insbesondere dort fest verbaut sind.

Der Roboter 6 transportiert das Substrat 1 zunächst in ein Plasmamodul 4. Das Plasmamodul 4 besitzt eine, insbesondere mit mehreren am oberen Umfang verteilten Öffnungen versehene, Gaszuführung 11 und einen, insbesondere mit mehreren am unteren Umfang verteilten Öffnungen versehenen, Abzug 12. Über die Gaszufuhr 11 wird das erfindungsgemäße Gasgemisch mit dem reduzierenden Gas in die Plasmakammer 4 eingeleitet. Die Zündung und/oder Aufrechterhaltung des Plasmas erfolgt anschließend zwischen einer unteren Elektrode 9 und einer oberen Elektrode 10. Das Substrat 1 liegt mit Vorzug direkt auf der Elektrode auf. Wenn das Substrat 1 auf dem Probenhalter 15 aufliegen sollte, muss der Probenhalter 15 erfindungsgemäß als Elektrode 9 ausgebildet sein.

Reduktionsprodukte werden mit Vorzug über einen Abzug 12, insbesondere kontinuierlich, aus der Plasmakammer 4 entfernt. Im Plasmamodul 4 erfolgt somit eine der erfindungsgemäßen Bearbeitungen der Oxidschicht 2.

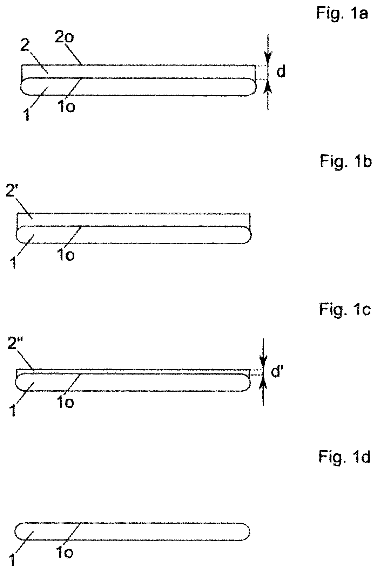

In einer erfindungsgemäßen Variante wird die Oxidschicht 2 durch das Plasma 13 in eine Oxidschicht 2' umgewandelt, welche sich durch eine unterschiedliche Stöchiometrie zur Oxidschicht 2 auszeichnet (Fig. 1b.). Die unterschiedliche Stöchiometrie kann dabei bereits bei der Abscheidung des Oxids durch einen Sauerstoffmangel hergestellt worden sein. Andernfalls kann durch eine gezielte Wahl der Prozessparameter die Stöchiometrie durch das Plasma eingestellt und/oder zumindest verändert werden.

In einer zweiten Variante wird die Oxidschicht 2 mit einer Ausgangsschichtdicke d durch reduzierende Gas im Plasma 13 zu einer Oxidschicht 2" mit einer Endschichtdicke d' gedünnt (Fig. 1c).

In einer weiteren Variante, die jedoch nicht zum Gegenstand der Erfindung gehört, erfolgt die vollständige Entfernung der Oxidschicht 2 (Fig. 1d).

Die Kontrolle über den Zustand des Oxids 2, 2', 2" erfolgt mit Vorzug über ein Quelle-Detektorsystem mit einer Quelle 18 und einem Detektor 19, mit welchem die Oberfläche 2o der Oxidschicht 2, 2', 2", mit Vorzug in-situ, untersucht werden kann. Die Quelle 18 und/oder der Detektor 19 kann/können sich innerhalb und/oder außerhalb des Plasmakammer 4 befinden. Befinden sie sich außerhalb, werden sie mit Vorzug über Flansche 17 mit der Plasmakammer 4, vakuumdicht, verbunden. Das Quelle-Detektorsystem kann jedes bekannte physikalische Messprinzip verwenden, welches geeignet ist, eine Aussage über den Zustand der Oxidschicht 2, 2', 2" zu machen. Dazu gehören die Dicke, die Porosität und damit die Dichte, sowie die Reflektivität der Oxidschicht 2, 2', 2".

Bevorzugt verwendet man Ellipsometer oder Diffraktometer, im Spezialfall Reflektometer.

Das so bearbeitete erste Substrat 1 wird gespeichert, insbesondere in einem im Arbeitsraum 22 angeordneten (nicht dargestellten) Vorratsbehälter.

Ein erfindungsgemäßes zweites Substrat 14, welches insbesondere ebenfalls an seiner Bondseite nach dem erfindungsgemäßen Prozess bearbeitet ist, wird mit oder zu dem präparierten ersten Substrat 1 in eine Bondkammer 5 transportiert. In der Bondkammer 5 erfolgt der Bondvorgang zwischen der Bondseite des ersten Substrats 1 und der Bondseite des zweiten Substrats 14. Dem Fachmann sind Bonder bekannt. Er weiß wie derartige Anlagen aufgebaut sind, wie Probenhalter 15 und/oder Druckplatten 16 gebaut sind, wie die Annäherung der beiden Substrate zueinander erfolgt, wie die Kraft zum Verbonden beider Substrate 1, 14 aufgebracht wird, wie die Evakuierung der Bondkammer 5 über einen Abzug 21 erfolgt. Der Probenhalter 15 kann als elektrostatischer Probenhalter und/oder Heizprobenhalter und/oder Kühlprobenhalter ausgeführt sein. Bevorzugt wird der Probenhalter 15 aus der Plasmakammer 4 zum Transport verwendet. Bei dem Probenhalter 15 handelt es sich bevorzugt um einen elektrostatischen Probenhalter, um eine gute thermische Ausdehnung des Substrats 1 an den Probenhalter 15 zu gewährleisten. Eine mechanische Klemmung oder eine Klemmung durch Vakuum würde eine freie thermische Ausdehnung des Substrats 1 nicht im gleichen Maß zulassen wie ein elektrostatischer Probenhalter 15. In einer ganz bevorzugten Ausführungsform wird der Probenhalter 15 von der Vorder- und/oder Rückseite mit He gespült, insbesondere über eine in den Probenhalter 15 eingebaute Spüleinrichtung, um die thermische Kopplung zu gewährleisten oder sogar zu verbessern.

Nach dem erfolgreichen Bondvorgang entnimmt der Roboter 6 den aus den beiden Substraten 1, 14 durch Bonden erzeugten Bondstack und speichert ihn, mit Vorzug im Voratsbehälter 8.

### Bezugszeichenliste

- 1: Substrat
- 1o: Substratoberfläche
- 2, 2', 2": Oxidschicht
- 2o: Oxidschichtoberfläche
- 3: Modulgruppe
- 4: Plasmakammer
- 5: Bondkammer
- 6: Roboter
- 7: Arbeitskammer
- 8: Vorratsbehälter
- 9: Untere Elektrode
- 10: Obere Elektrode
- 11: Gaszuführung
- 12: Abzug
- 13: Plasmagas
- 14: Zweites Substrat
- 15: Probenhalter
- 16: Druckplatte
- 17: Flansch
- 18: Quelle
- 19: Detektor
- 20: Bondplasmakammer
- 21: Abzug
- 22: Arbeitsraum
- d, d': Oxidschichtdicke

## Patentansprüche

1. Verfahren zum Erzeugen eines elektrisch leitfähigen Direktbonds zwischen einer Bondseite eines ersten Substrats (1) und einer Bondseite eines zweiten Substrats (14) in einem zur Umgebung gasdicht schließbaren und mit Vakuum beaufschlagbaren Arbeitsraum (22), in dem
a) mindestens eine der Bondseiten in einer Plasmakammer (4) modifiziert und anschließend in einer Bondkammer (5) die mindestens eine modifizierte Bondseite mit der Bondseite des zweiten Substrats (14) gebondet wird und/oder
b) mindestens eine der Bondseiten in einer Bondplasmakammer (20) modifiziert und anschließend in der Bondplasmakammer (20) die mindestens eine modifizierte Bondseite mit der Bondseite des zweiten Substrats (14) gebondet wird,
**dadurch gekennzeichnet, dass**
die Modifizierung mindestens einer der Bondseiten durch Änderung der Stöchiometrie einer Oxidschicht (2) auf mindestens einer der Bondseiten erfolgt, und wobei
zur Modifizierung eines oder mehrere der nachfolgend aufgeführten reduzierenden Gase in die Plasmakammer (4) eingeleitet wird:
- Wasserstoff,
- Stickoxide,
- Kohlenmonoxid,
- Methan,
und wobei das reduzierende Gas mit einem oder mehreren der nachfolgend aufgeführten Inertgas gemischt wird:
- Xenon,
- Argon,
- Helium,
- Stickstoff,
- Kohlendioxid.

2. Verfahren nach Anspruch 1, bei dem die Modifizierung durch:
a) Veränderung einer Oxidschicht (2) auf mindestens einer der Bondseiten und/oder
b) zumindest teilweises Abtragen eines Teils einer Oxidschicht (2) von mindestens einer der Bondseiten erfolgt.

3. Verfahren nach Anspruch 1 oder 2, bei dem die Bondschicht mit einer Ionenenergie von weniger als 1000eV, insbesondere weniger als 500eV, vorzugsweise weniger als 250eV beaufschlagt wird, die zwischen einer oberen Elektrode (10) und einer unteren Elektrode (9) der Plasmakammer (4) und/oder der Bondplasmakammer (20) angelegt wird.

4. Verfahren nach Anspruch 3, bei dem an der oberen Elektrode (10) eine Wechselspannung mit einer Frequenz größer als die Frequenz der an der unteren Elektrode angelegten Wechselspannung beaufschlagt wird.

## Claims

1. A method for producing an electrically conductive direct bond between a bonding side of a first substrate (1) and a bonding side of a second substrate (14) in a workspace (22) that can be closed, gas-tight, against the environment and can be supplied with a vacuum, in which
a) at least one of the bonding sides is modified in a plasma chamber (4) and subsequently the at least one modified bonding side is bonded with the bonding side of the second substrate (14) in a bonding chamber (5) and/or
b) at least one of the bonding sides is modified in a bonding/plasma chamber (20) and subsequently the at least one modified bonding side is bonded with the bonding side of the second substrate (14) in the bonding/plasma chamber (20),
**characterised in that**
the modification of at least one of the bonding sides takes place by changing the stoichiometry of an oxide layer (2) on at least one of the bonding sides, and wherein one or more of the following specified reducing gases is introduced into the plasma chamber (4) for the modification:
- Hydrogen,
- Nitrogen oxides,
- Carbon monoxide,
- Methane,
and wherein the reducing gas is mixed with one or more of the following specified inert gases:
- Xenon,
- Argon,
- Helium,
- Nitrogen,
- Carbon dioxide.

2. The method according to claim 1, in which the modification takes place by:
a) altering an oxide layer (2) on at least one of the bonding sides and/or
b) at least partial removal of a part of an oxide layer (2) from at least one of the bonding sides.

3. The method according to claim 1 or 2, in which the bonding layer is exposed to an ion energy of less than 1000eV, especially less than 500eV, preferably less than 250eV, which is applied between an upper electrode (10) and a lower electrode (9) of the plasma chamber (4) and/or the bonding/plasma chamber (20).

4. The method according to claim 3, in which an alternating voltage with a frequency greater than the frequency of the alternating voltage applied to the lower electrode is supplied to the upper electrode (10).

## Revendications

1. Procédé pour produire une liaison directe conductrice d'électricité entre un côté de liaison d'un premier substrat (1) et un côté de liaison d'un second substrat (14) dans un espace de travail (22) pouvant être fermé en étanchéité aux gaz par rapport à l'environnement et pouvant recevoir du vide, dans lequel
a) au moins un des côtés de liaison est modifié dans une chambre de plasma (4) et ensuite, l'au moins un côté de liaison modifié est lié au côté de liaison du second substrat (14) dans une chambre de liaison (5) et/ou
b) au moins un des côtés de liaison est modifié dans une chambre de plasma de liaison (20) et ensuite, l'au moins un côté de liaison modifié est lié au côté de liaison du second substrat (14) dans la chambre de plasma de liaison (20),
**caractérisé en ce que**
la modification d'au moins un des côtés de liaison est effectuée par modification de la stœchiométrie d'une couche d'oxyde (2) sur au moins un des côtés de liaison, et dans lequel pour modifier un ou plusieurs des gaz réducteurs listés ci-après, est introduit dans la chambre de plasma (4) :
- de l'hydrogène
- de l'oxyde d'azote,
- du monoxyde de carbone,
- du méthane,
et dans lequel le gaz réducteur est mélangé à un ou plusieurs des gaz inertes listés ci-dessous :
- xénon
- argon
- hélium
- azote,
- dioxyde de carbone.

2. Procédé selon la revendication 1, dans lequel la modification est effectuée par :
a) modification d'une couche d'oxyde (2) sur au moins un des côtés de liaison et/ou
b) enlèvement au moins partiel d'une partie d'une couche d'oxyde (2) d'au moins un des côtés de liaison.

3. Procédé selon la revendication 1 ou 2, dans lequel la couche de liaison reçoit une énergie de ions inférieure à 1000eV, en particulier inférieure à 500eV, de préférence inférieure à 250eV, qui est appliquée entre une électrode supérieure (10) et une électrode inférieure (9) de la chambre de plasma (4) et/ou de la chambre de plasma de liaison (20).

4. Procédé selon la revendication 3, dans lequel une tension alternative ayant une fréquence supérieure à la fréquence de la tension alternative appliquée sur l'électrode inférieure est appliquée sur l'électrode supérieure (10).
